# FASCICULE DE BREVET EUROPEEN

(11) **EP 0 696 081 B1**
(45) Date de publication et mention de la délivrance du brevet: **23.09.1998**
(21) Numéro de dépôt: 95401806.5
(22) Date de dépôt: 01.08.1995
(51) Int. Cl.: H01R 4/68, H02G 15/34

(54) **Liaison électrique supraconductrice**
Supraleitende elektrische Verbindung
Superconductive electrical connection

(30) Priorité: 04.08.1994 FR 9409708
(43) Date de publication de la demande: 07.02.1996
(73) Titulaire: ALCATEL ALSTHOM COMPAGNIE GENERALE D'ELECTRICITE, 75382 Paris Cédex 08 (FR)
(72) Inventeur: Herrman, Peter Friedrich, Corbreuse, F-91410 Dourdan (FR); Mirebeau, Pierre, F-91140 Villebon (FR); Verhaege, Thierry, F-91160 Saulx-les-Chartreux (FR)
(74) Mandataire: Pothet, Jean Rémy Emile Ludovic

(56) Documents cités:
- EP-A- 0 520 374
- DE-A- 2 535 487
- DE-A- 4 208 378
- US-A- 4 485 266

## Description

La présente invention est relative à une liaison électrique supraconductrice permettant d'assurer une double fonction de transport de courant et de limitation de courant.

L'invention trouve une application particulière, mais non limitative, dans les groupes de production d'énergie électrique dans lesquels on trouve un générateur à moyenne tension (par exemple 20 kV) relié, par une liaison de quelques centaines de mètres, à un poste de transformation moyenne tension/haute tension (par exemple 20kV/400 kV). Le courant traversant la liaison est très élevé (par exemple de l'ordre de 20 kA); on utilise généralement des conducteurs de forte section (diamètre: 500 mm) refroidis par un fluide (généralement de l'air) circulant dans un conduit métallique de grand diamètre (typiquement 1 mètre). Les pertes dans une telle liaison sont de l'ordre de 3000kW/km/GW.

Il a été envisagé de réaliser cette liaison au moyen de supraconducteurs à basse température critique, qui permettent de transporter de très hautes densités de courant avec de très faibles pertes. Ce type de liaison nécessite un équipement cryogénique important et complexe, en raison de la basse température à maintenir qui est voisine de la température de liquéfaction de l'hélium (4,2 K). Par ailleurs, un isolement important donc coûteux est nécessaire pour limiter les pertes cryogéniques à un niveau acceptable. C'est la raison pour laquelle il n'existe pas à ce jour de telles liaisons.

L'apparition des céramiques supraconductrices à haute température critique, par exemple supérieure à celle de l'azote liquide, permet d'envisager des réalisations favorables des points de vue économique et technique.

Par ailleurs a été étudiée l'utilisation de supraconducteurs pour la limitation des courants de court-circuit. On utilise la propriété du matériau supraconducteur de passer, au-delà d'une valeur critique de courant, d'un état supraconducteur où sa résistance est quasi nulle, à un état dit normal où sa résistance devient très élevée. Il est ainsi possible de limiter la valeur d'un courant de court-circuit à une valeur déterminée, par exemple 5 fois la valeur du courant nominal, alors que sans cette limitation il pourrait atteindre par exemple au moins 20 fois la valeur du courant nominal. Cette limitation permet d'éviter toutes les dégradations susceptibles d'être engendrées par le courant de court-circuit et par suite, permet un gain important sur le dimensionnement des lignes, des générateurs, des transformateurs et des appareils de coupure.

Le limiteur de courant est considéré habituellement comme un appareillage supplémentaire, à installer en série sur la ligne qu'on veut protéger.

Un but de la présente invention est de réaliser une liaison supraconductrice qui joue les deux rôles de transport du courant et de limiteur de courant et qui en apporte les avantages et performances.

L'invention a ainsi pour objet une liaison électrique pour le transport du courant et sa limitation, caractérisé en ce qu'elle comprend une pluralité de portions tubulaires en matériau supraconducteur à haute température critique reliées bout à bout par des jonctions flexibles en métal ou alliage bon conducteur, un premier tube parcouru par un fluide cryogénique s'étendant à l'intérieur desdites portions tubulaires, et desdites jonctions flexibles et un second tube dans lequel règne le vide s'étendant autour desdites portions tubulaires.

D'autres particularités et avantages de l'invention apparaîtront à la lecture de la description ci-après d'un exemple de réalisation de l'invention, en référence au dessin ci-annexé dans lequel:
- la figure 1 est une vue en coupe axiale d'une phase d'une liaison selon l'invention,
- la figure 2 est une vue agrandie montrant un exemple de réalisation d'une jonction entre deux portions tubulaires supraconductrices.

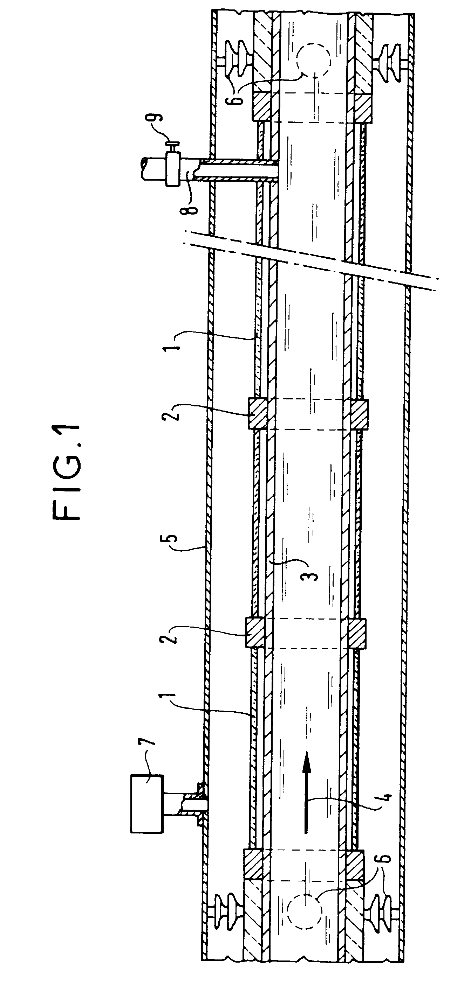

La figure 1 est une vue schématique d'une phase d'une liaison selon l'invention; une liaison triphasée comprendra trois liaisons monophasées identiques, disposées en nappe ou en trièdre.

La liaison monophasée de la figure 1 comprend une pluralité de portions tubulaires 1 en matériau supraconducteur à haute température critique, par exemple en céramique de formule Bi2Sr2CoCu2O8; les portions ont par exemple une longueur voisine de 10 mètres.

Les portions sont placées bout à bout et reliées deux à deux par une jonction métallique flexible 2, réalisée de préférence en cuivre ou alliage ayant une bonne conductivité électrique. La flexibilité des jonctions permet de donner à la liaison une forme courbe si nécessaire.

Le refroidissement des portions tubulaires supraconductrices est assuré par un fluide cryogénique circulant dans un tube 3 disposé intérieurement aux portions tubulaires 1; la circulation est symbolisée dans la figure 1 par la flêche 4; le fluide cryogénique est de l'azote liquide à la pression atmosphérique, dont la température est comprise entre 65 et 77 K.

L'isolement électrique est assuré par le vide pratiqué à l'intérieur d'un tube métallique 5, par exemple en acier, entourant l'ensemble des portions tubulaires supraconductrices 1. Le tube est maintenu aux extrémités par des isolateurs 6; il peut être prévu des isolateurs intermédiaires non représentés.

Le vide est réalisé au moyen d'un groupe de pompage 7.

De place en place, l'intérieur du tube 3 est mis en communication avec l'extérieur par des conduits 8 munis de vannes unidirectionnelles telles que 9 pour assurer l'évacuation de l'azote gazeux résultant de l'évaporation de l'azote liquide qui intervient lors d'une transition des portions supraconductrices à l'état normal, en cas de court-circuit par exemple.

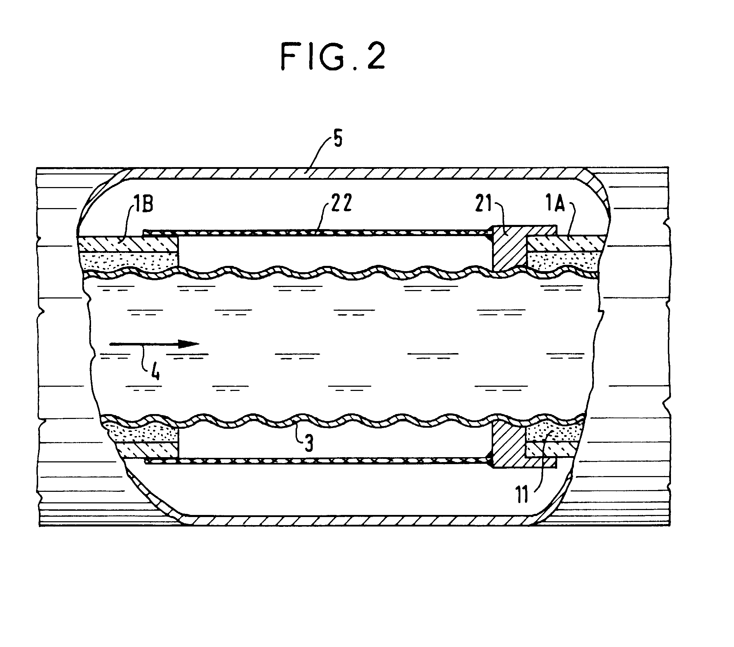

La figure 2 est une vue agrandie d'une portion de la figure 1, montrant notamment la réalisation des jonctions entre portions supraconductrices.

Une jonction est typiquement constituée par un anneau de cuivre 21, soudé d'une part à l'une des portions supraconductrices à relier, la portion 1A dans la figure 2, et, d'autre part, à une première extrémité d'une tresse métallique 22 qui vient en appui par sa seconde extrémité sur la seconde portion supraconductrice à relier. La souplesse de la tresse 22 confère à la jonction la flexibilité nécessaire pour permettre de réaliser les courbures nécessaires de la liaison. La tresse assure en outre la compensation des dilatations différentielles qui se produisent par exemple lors de la mise en froid de la liaison, par glissement à l'extrémité des portions tubulaires supraconductrices.

Le tube 3 de refroidissement 3 est de préférence réalisé de manière corruguée, ce qui lui confère une certaine flexibilité. L'espace entre le tube 3 et les éléments tubulaires 1 est rempli par une matière de remplissage 11 assurant un bon contact thermique entre le tube 3 et les éléments tubulaires supraconducteurs; une telle matière est par exemple une résine époxy ou polyuréthane, ou de préférence du polyamide 6 (LUTRAMID B4 de BASF).

Un exemple de mise en oeuvre de l'invention est décrit maintenant. Il s'agit d'une liaison triphasée de 1 GW ayant une longueur de 400 mètres, destinée à véhiculer 28 kA nominaux sous une tension simple de 20kV.

Chaque liaison de phase possède les éléments décrits plus haut à savoir, un conducteur supraconducteur, un tube de refroidissement et un tube d'isolement. Les données ci-dessous concernent une liaison de phase.

La liaison de phase est constituée de 40 portions tubulaires en céramique Bi2Sr2CoCu2O8 ayant chacune un diamètre de 200 mm, et une longueur de 10 mètres. On admet qu'en régime supraconducteur, la densité de courant est de 100A/mm².

Le diamètre intérieur du tube de refroidissement, réalisé en cuivre, est de l'ordre de 100 mm et son épaisseur est de 4 mm. L'azote liquide utilisé en fonctionnement normal est de l'azote sous-refroidi injecté à une extrémité de la liaison de phase à 65 K et recueilli à l'autre extrémité à 75 K. Le débit est voisin de 1,8 kg/s.

Le tube extérieur en acier a un diamètre extérieur de l'ordre de 750 mm et une épaisseur de l'ordre de 5 mm; le vide est maintenu voisin de 1 Torr.

Le fonctionnement de la liaison présente les caractéristiques suivantes:
- **en régime de fonctionnement normal**
   Les pertes de la liaison triphasée sont de l'ordre de 100 kW au total, ce qui comprend les pertes Joules dues au conducteur et aux jonctions, ainsi que les pertes thermiques. La machine cryogénique chargée de compenser ces pertes absorbera environ 1 MW électrique. Ceci représente 1 pour mille de la puissance transitée dans la liaison. Ceci est à rapprocher du chiffre de 1,2 pour mille qui serait le ratio correspondant dans une liaison classique de 400 m de longueur.
- **en régime limiteur**
   On dimensionne la liaison pour que la limitation du courant se fasse à une valeur égale à 5 fois la valeur de l'intensité nominale In, soit 5In = 140 kA.
   Le calcul montre que la température du supraconducteur va croître jusqu'à 130 K environ, ce qui est acceptable, et que, dans ces conditions, dans chaque phase, environ 100 kg ou 125 litres d'azote seront vaporisés, soit la production de près de 100 mètres cube de vapeurs. Ceci ne correspond qu'à une fraction faible de la quantité totale d'azote contenu dans le tube de la liaison, de sorte que le système reste froid à la température de 77K et peut être mis rapidement en état de fonctionner.

## Revendications

1. Liaison électrique pour le transport du courant et sa limitation, caractérisé en ce qu'elle comprend une pluralité de portions tubulaires (1) en matériau supraconducteur à haute température critique reliées bout à bout par des jonctions flexibles (2) en métal ou alliage bon conducteur, un premier tube (3) parcouru par un fluide cryogénique s'étendant à l'intérieur desdites portions tubulaires (1), et desdites jonctions flexibles (2) et un second tube (5) dans lequel règne le vide s'étendant autour desdites portions tubulaires (1).

2. Liaison électrique selon la revendication 1, caractérisée en ce que les jonctions flexibles (2) comprennent un anneau (21) solidarisé à une tresse (22).

3. Liaison électrique selon l'une des revendications 1 et 2, caractérisée en ce qu'un matériau de remplissage (11) est disposé entre les portions tubulaires supraconductrices (1) et ledit premier tube (3).

4. Liaison électrique selon la revendication 3, caractérisée en ce que ledit matériau de remplissage (11) est choisi parmi la famille des polyamides, résines époxy et polyuréthane.

5. Liaison électrique selon l'une des revendications 1 à 4, caractérisée en ce que ledit premier tube (3) est corrugué afin de lui procurer une certaine flexibilité.

6. Liaison électrique selon l'une des revendications 1 à 5, cartactérisée en ce que ledit premier tube (3) est en communication avec l'extérieur par des liaisons (8) munies de vannes unidirectionnelles (9).

7. Liaison électrique selon l'une des revendications 1 à 6, cartactérisée en ce que ledit second tube (5) est relié à au moins un organe de pompage (7).

8. Liaison électrique selon l'une des revendications 1 à 7, caractérisée en ce que le matériau des portions tubulaires supraconductrices est une céramique du type Bi2Sr2CoCu2O8.

9. Liaison électrique selon l'une des revendications 1 à 8, caractérisée en ce que le fluide cryogénique est de l'azote à une température comprise entre 65 et 77 K.

## Patentansprüche

1. Supraleitende elektrische Verbindung für den Transport des Stroms und seine Begrenzung, dadurch gekennzeichnet, daß sie eine Mehrzahl von rohrförmigen Abschnitten (1) aus supraleitendem Material mit hoher kritischer Temperatur umfaßt, die Ende an Ende durch flexible Übergänge (2) aus einem Metall oder einer Legierung mit guter Leitfähigkeit verbunden sind, wobei ein von einem Kühlfluid durchströmtes erstes Rohr (3) sich im Innern der rohrförmigen Abschnitte und der flexiblen Übergänge (2) erstreckt und ein zweites Rohr, in dem Vakuum herrscht, sich um die rohrförmigen Abschnitte (1) erstreckt.

2. Elektrische Verbindung nach Anspruch 1, dadurch gekennzeichnet, daß die flexiblen Übergänge (2) einen mit einer Litze (22) fest verbundenen Ring (21) umfassen.

3. Elektrische Verbindung nach einem der Ansprüche 1 und 2, dadurch gekennzeichnet, daß ein Füllmaterial (11) zwischen dem supraleitenden rohrförmigen Abschnitten (1) und dem ersten Rohr (3) angeordnet ist.

4. Elektrische Verbindung nach Anspruch 3, dadurch gekennzeichnet, daß das Füllmaterial (11) aus der Familie der Polyamide, Epoxiharze und Polyurethan ausgewählt ist.

5. Elektrische Verbindung nach einem der Ansprüche 1 bis 4, dadurch gekennzeichnet, daß das erste Rohr (3) gewellt ist, um ihm eine gewisse Flexibilität zu verschaffen.

6. Elektrische Verbindung nach einem der Ansprüche 1 bis 5, dadurch gekennzeichnet, daß das erste Rohr (3) mit der Umgebung durch Verbindungen (8) kommuniziert, die mit Einwegventilen (9) versehen sind.

7. Elektrische Verbindung nach einem der Ansprüche 1 bis 6, dadurch gekennzeichnet, daß das zweite Rohr (5) mit wenigstens einem Pumporgan (7) verbunden ist.

8. Elektrische Verbindung nach einem der Ansprüche 1 bis 7, dadurch gekennzeichnet, daß das Material der rohrförmigen supraleitenden Abschnitte eine Keramik vom Typ Bi2Sr2CoCu2O8 ist.

9. Elektrische Verbindung nach einem der Ansprüche 1 bis 8, dadurch gekennzeichnet, daß das Kühlfluid Stickstoff bei einer Temperatur zwischen 65 und 77 K ist.

## Claims

1. Electrical transmission line for conveying and limiting current characterised in that it comprises a plurality of tubular portions (1) made from a superconductive material having a high critical temperature connected end-to-end by flexible good electrical conductor metal or alloy joints (2), a first tube (3) inside said tubular portions and said flexible joints (2) in which a cryogenic fluid flows and a second tube (5) around said tubular portions (1) in which a vacuum is maintained.

2. Electrical transmission line according to claim 1 characterised in that the flexible joints (2) comprise a ring (21) attached to a braid (22).

3. Electrical transmission line according to claim 1 or claim 2 characterised in that a filling material (11) is disposed between the tubular superconductor portions (1) and said first tube (3).

4. Electrical transmission line according to claim 3 characterised in that said filling material (11) is selected from polyamides, epoxy resins and polyurethane resins.

5. Electrical transmission line according to any one of claims 1 to 4 characterised in that said first tube (3) is corrugated to impart some flexibility to it.

6. Electrical transmission line according to any one of claims 1 to 5 characterised in that said first tube (3) communicates with the outside via transmission lines (8) incorporating one-way valves (9).

7. Electrical transmission line according to any one of claims 1 to 6 characterised in that said second tube (5) is connected to at least one pump set (7).

8. Electrical transmission line according to any one of claims 1 to 7 characterised in that the material of said superconductor portions is a Bi2Sr2CoCu2O8 type ceramic.

9. Electrical transmission line according to any one of claims 1 to 8 characterised in that the cryogenic fluid is nitrogen at a temperature in the range 65 K to 77 K.
